# FASCICULE DE BREVET EUROPEEN

(11) **EP 2 009 697 B1**
(45) Date de publication et mention de la délivrance du brevet: **17.11.2010**
(21) Numéro de dépôt: 08305273.8
(22) Date de dépôt: 17.06.2008
(51) Int. Cl.: H01L 27/146, H01L 21/60

(54) **Procédé pour la réalisation d'une matrice de détection de rayonnements électromagnétiques et procédé pour remplacer un module élémentaire d'une telle matrice de détection**
Herstellungsverfahren für einen matrixförmigen Strahlungsdetektor sowie Verfahren zum Austausch einzelner Detektionsmodule in dieser Matrix
Fabrication process of a matrix-shaped radiation detector and process for exchanging single detection modules of this matrix

(30) Priorité: 27.06.2007 FR 0756069
(43) Date de publication de la demande: 31.12.2008
(73) Titulaire: Société Française de Détecteurs Infrarouges - SOFRADIR, 92290 Châtenay Malabry (FR)
(72) Inventeur: Pitault, M. Bernard, 38960 Saint Etienne de Crossey (FR)
(74) Mandataire: Vuillermoz, Bruno

(56) Documents cités:
- EP-A- 0 665 594
- DE-A1- 3 042 085
- DE-A1- 19 738 399
- US-A- 5 186 383
- US-A1- 2003 060 035
- US-A1- 2006 202 318
- US-B1- 6 175 157
- PUTTLITZ SR K J: "AN OVERVIEW OF FLIP-CHIP REPLACEMENT TECHNOLOGY ON MLC MULTICHIP MODULES" INTERNATIONAL JOURNAL OF MICROCIRCUITS AND ELECTRONIC PACKAGING, INTERNATIONAL MICROELECTRONICS & PACKAGING SOCIETY, US, vol. 15, no. 3, septembre 1992 (1992-09), pages 113-126, XP000360150 ISSN: 1063-1674

## Description

### DOMAINE DE L'INVENTION

La présente invention a trait au domaine des détecteurs de rayonnements électromagnétiques, et notamment dans le domaine du spectre infrarouge et visible. Elle concerne plus particulièrement la réalisation de très grands plans focaux, typiquement supérieurs à 100 mm, et notamment leur réparation.

### ETAT ANTERIEUR DE LA TECHNIQUE

Les détecteurs de rayonnements électromagnétiques sont classiquement constitués d'un circuit de détection desdites ondes à détecter, et donc sensibles à la gamme de longueurs d'onde correspondante, transformant de manière connue un rayonnement électromagnétique en un signal électrique. Ce circuit de détection est associé à un circuit électronique de lecture, destiné à transformer les signaux électriques issus du circuit de détection pour les rendre susceptibles de subir un traitement ultérieur, notamment après amplification.

De manière connue également, la liaison tant mécanique qu'électrique intervenant entre le circuit de détection et le circuit de lecture s'effectue par la technologie dite d'hybridation par billes ou microbilles, également dénommée sous l'expression anglo-saxonne *« flip chip* ». Ces billes ou microbilles sont réalisées en indium, voire en alliage étain/plomb.

Le circuit de détection est traditionnellement composé d'un matériau transparent ou peu absorbant du rayonnement à détecter, et est par exemple constitué de CdTe, CdZnTe, voire de germanium, sur lequel est déposé par épitaxie (en phase liquide, en phase vapeur, voire par jet moléculaire) une couche mince absorbante de HgCdTe constituant le circuit de détection proprement dit.

Le circuit de lecture est le plus souvent réalisé en silicium.

Ces différentes technologies sont aujourd'hui bien maîtrisées.

Cependant, les évolutions observées dans le domaine de la détection, et plus particulièrement dans le domaine spatial, nécessitent de faire appel à des plans focaux de très grandes dimensions, typiquement supérieures à 100 millimètres. Ceci impose, s'agissant de l'élément de détection proprement dit, la mise en oeuvre de plusieurs modules élémentaires de détection aboutés l'un à l'autre ou disposés en quinconce. Or, de tels systèmes de détection ont un certain nombre d'exigences liées notamment à la focalisation, à la reconstitution d'une barrette de détection de très grandes dimensions..., qui imposent dès lors des contraintes sur les positionnements relatifs des divers modules élémentaires, d'une part dans les deux dimensions du plan dans lequel ils sont inscrits (cotes X, Y), et d'autre part sur la dispersion selon la cote Z, c'est-à-dire selon la direction perpendiculaire au plan des diverses diodes constituant le plan focal.

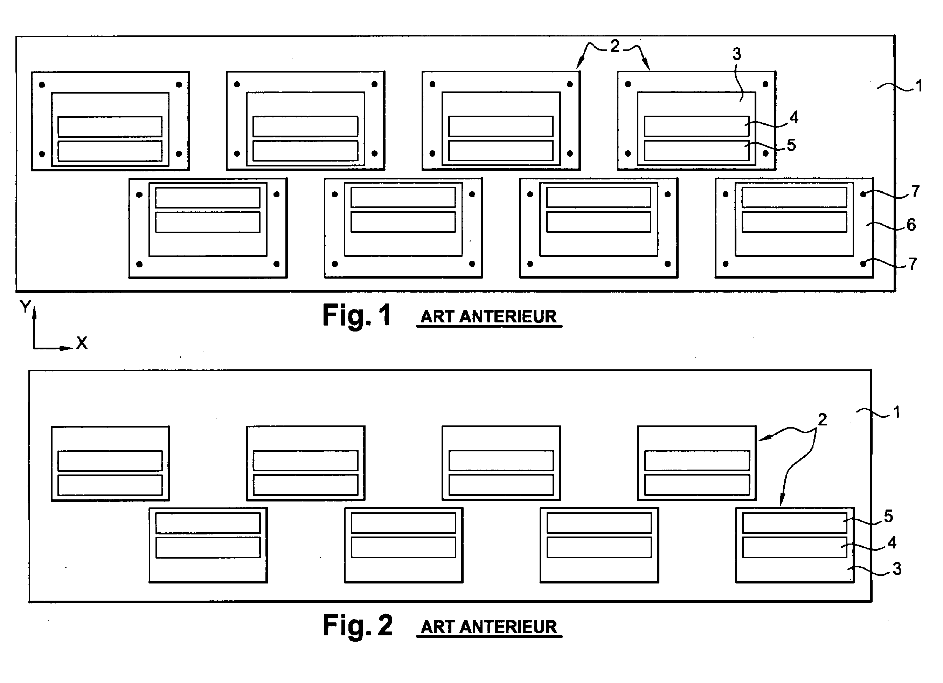

Parmi les solutions techniques proposées à ce jour, on a tout d'abord proposé la fixation mécanique des différents modules élémentaires constitutifs du plan focal par vissage ou clampage sur le réseau ou substrat d'interconnexion. On a représenté en relation avec la figure 1, une illustration de cette technologie. On a ainsi représenté par la référence **1** le substrat d'interconnexion et par la référence **2** les différents modules élémentaires montés en quinconce, propres à constituer la barrette de détection.

Chacun de ces modules **2** comporte un circuit de lecture **3,** et dans l'exemple décrit deux circuits de détection **4, 5** correspondant à deux gammes de longueurs d'onde différentes. Chacun de ces modules **2** est collé sur une semelle de report **6,** typiquement réalisée en molybdène, le vissage ou le clampage **7** ne pouvant s'effectuer directement sur le circuit de lecture.

On a également proposé (voir figure 2) un maintien mécanique des différents modules élémentaires par collage. Selon cette technologie, chacun des modules élémentaires **2** est positionné sur le réseau ou substrat d'interconnexion **1,** et son maintien en position est assuré par polymérisation d'un lit de colle déposé entre le circuit de lecture **3** et ledit substrat d'interconnexion.

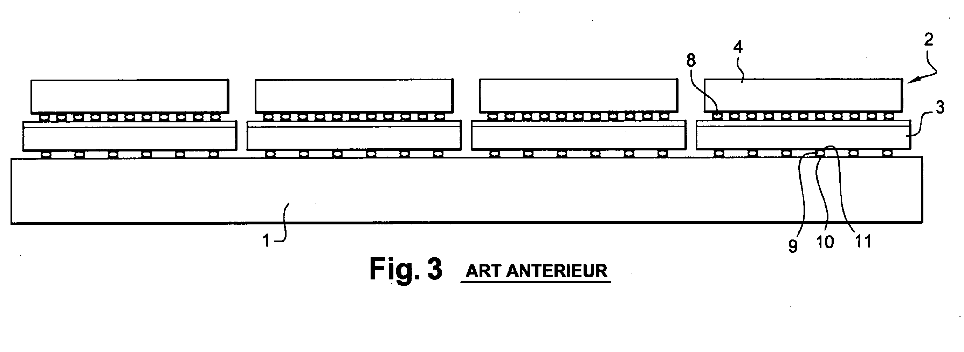

Enfin on a proposé (voir figure 3), un mode de fixation des modules élémentaires **2** sur le substrat d'interconnexion **1** par hybridation, mettant en oeuvre là encore la technologie « *Flip Chip* ».

Le maintien en position peut, dans le cas d'espèce, être renforcé par polymérisation d'une colle que l'on aura fait migrer entre le circuit de lecture 3 et le réseau d'interconnexion **1** (*underfilling*) *-* cela ne peut constituer qu'un renfort éventuel du maintien.

US6175157 B1 décrit un procédé pour la réalisation d'une matrice de puces, qui sont associées à un substrat d'interconnexion par un premièr réseau de billes d'hybridation. Pour éviter les problèmes de voilure des puces, un second réseau de billes est positionné entre chaque puce et le substrat d'interconnexion. Le volume desdites billes du second réseau est inférieur à ce dudit premier réseau. Les billes du second réseau ne forment pas une connexion électrique entre le substrat d'interconnexion et les puces.

XP000360150 décrit des procédés pour retirer un module dégradé afin de le remplacer. Tous les procédés proposés dans XP000300150 détruisent les billes d'hybridation et il reste des debris à l'endroit où la bille a été rétireé.

Quelle que soit la technologie mise en oeuvre, une difficulté se fait jour lorsque l'on observe que l'un ou plusieurs des détecteurs ne satisfont plus aux performances prescrites, notamment en suite d'une dégradation accidentelle, voire lorsque l'on constate une évolution de performance d'un ou plusieurs module(s) élémentaire(s) entre la phase de tri desdits modules et la phase de test après assemblage final sur le substrat d'interconnexion.

En effet, le remplacement d'un tel module élémentaire défaillant ne doit pas affecter les modules adjacents. En outre, la mise en place d'un nouveau module doit répondre aux spécifications électro-optiques requises.

Enfin, on doit conserver après remplacement d'un tel module élémentaire les spécifications géométriques, notamment au niveau du plan focal final, le positionnement des photosites en X, Y et Z.

A ce jour, on ne connaît pas de méthode permettant de procéder ainsi au remplacement d'un module élémentaire défectueux.

C'est l'objet de la présente invention de proposer une telle méthode.

### EXPOSE DE L'INVENTION

La présente invention vise ainsi tout d'abord un procédé pour la réalisation d'une matrice de détecteurs de rayonnements électromagnétiques. Cette matrice est constituée d'une pluralité de modules de détection élémentaires, rapportés sur un substrat d'interconnexion, lesdits modules étant eux-mêmes composés d'au moins un circuit de détection dudit rayonnement associé à un circuit de lecture par hybridation, ledit circuit de lecture étant lui-même solidarisé au substrat d'interconnexion par hybridation.

Selon l'invention, ce procédé consiste :
- à déposer sur le substrat d'interconnexion un nombre déterminé de quantités de matériau de brasure ou d'hybridation, destinées à constituer les billes d'hybridation, et ce selon au moins deux réseaux, au moins le réseau utilisé pour l'hybridation nominale étant relié à des plots d'interconnexion par le biais de pistes métalliques conductrices, les dépôts de matériau de brasure ou d'hybridation de l'autre ou des autres réseaux étant inférieurs en volume à ceux dudit réseau d'hybridation nominale ;
- à déposer sur le substrat d'interconnexion ainsi muni des au moins deux réseaux de matériau de brasure, un flux de matériau sous forme liquide remplissant les fonctions de désoxydation dudit matériau de brasure ou d'hybridation, de limitation de ré-oxydation dudit matériau après réalisation effective de ladite brasure, de transfert de chaleur, outre de diminution des tensions de surface ;
- à rapporter les modules élémentaires à hybrider sur le substrat d'interconnexion ;
- puis à élever la température de l'enceinte au sein de laquelle sont positionnés les différents éléments à hybrider jusqu'à atteindre au moins la température de fusion du matériau de brasure ou d'hybridation afin d'assurer la brasure ou l'hybridation effective des modules sur le substrat d'interconnexion entre eux par effet de refusion.

En d'autres termes, l'invention consiste à ménager au moins deux réseaux d'éléments différents adaptés pour réaliser l'hybridation des modules élémentaires sur le substrat d'interconnexion :
■ un premier réseau, destiné de manière traditionnelle à assurer l'hybridation dite « nominale » du ou des modules élémentaires sur le substrat d'interconnexion ;
■ et au moins un second réseau, de dimensions plus réduites, et notamment de volume inférieur donc de hauteur plus faible que le premier réseau, de telle sorte à ne pas venir en contact avec le ou lesdits modules élémentaires lors de la réalisation de l'hybridation nominale, et destiné, après remplacement éventuel d'un module élémentaire défectueux ou non conforme aux préconisations prescrites, à permettre néanmoins la réalisation d'une nouvelle hybridation d'un module élémentaire de remplacement.

L'invention concerne donc également un procédé pour remplacer un module de détection élémentaire rapporté par hybridation sur un substrat d'interconnexion comportant une pluralité de tels modules élémentaires juxtaposés ou aboutés les uns à coté des autres afin de définir un plan focal de grandes dimensions. Ces modules élémentaires sont rapportés sur le substrat d'interconnexion par un premier réseau de billes d'hybridation, notamment réalisées en indium ou en alliage étain/plomb, lesdites billes étant connectées à un ou plusieurs plot(s) de connexion externes par une ou plusieurs pistes conductrices. Le substrat d'interconnexion comporte également au moins un second réseau de billes d'hybridation, dont les dimensions sont inférieures à celles des billes dudit premier réseau d'hybridation.

Ce procédé consiste :
- tout d'abord, à retirer la couche de protection dont sont revêtus le ou les plot(s) de connexion externe(s) relié(s) électriquement audit premier réseau de billes d'hybridation, dite hybridation nominale ;
- puis à faire migrer, notamment par capillarité, une solution conductrice entre ledit module élémentaire à remplacer et le substrat d'interconnexion, afin d'induire par réaction électrochimique la dissolution à tout le moins partielle dudit premier réseau de billes d'hybridation ;
- à retirer le module à remplacer ;
- puis à hybrider le module de remplacement par une nouvelle élévation de température de l'enceinte dans laquelle est située l'ensemble à une température au moins égale à la température de fusion du matériau constitutif desdites billes d'hybridation du second réseau, pour assurer la solidarisation par refusion.

Avantageusement, le module de remplacement comporte un circuit de détection (ou de lecture) plus épais que le circuit de détection (ou de lecture) du module remplacé, afin de compenser la variation de hauteur des billes d'hybridation entre les deux réseaux.

En outre, selon une variante de l'invention, le dépôt de la solution électriquement conductrice est réalisé sur la face arrière du module élémentaire à remplacer.

### BREVE DESCRIPTION DES DESSINS

La manière dont l'invention peut être réalisée et les avantages qui en découlent ressortiront mieux de l'exemple de réalisation qui suit, donné à titre indicatif et non limitatif à l'appui des figures annexées.
La figure 1 est une représentation schématique vue du dessus d'une technologie de l'art antérieur mettant en oeuvre le clampage ou vissage mécanique des modules élémentaires sur le substrat d'interconnexion.
La figure 2, également déjà décrite, est une représentation schématique de la technologie de l'art antérieur vue du dessus, mettant en oeuvre la technologie du collage des modules élémentaires sur le substrat d'indexation.
La figure 3 est une vue schématique en section longitudinale d'une autre technologie de l'art antérieur, mettant en oeuvre l'hybridation des modules élémentaires sur le substrat d'interconnexion.
La figure 4 est une représentation schématique en section de l'hybridation d'un module élémentaire conforme à l'invention, avant réparation ou remplacement.
La figure 5 est une vue analogue à la figure 4, après remplacement.
La figure 6 est une vue du dessus de l'implantation des billes d'hybridation selon une forme particulière de réalisation de l'invention.
La figure 7 est une représentation schématique en section d'un plan focal nominal, c'est à dire ne comportant que des modules élémentaires originaux.
La figure 8 est une représentation schématique en section d'un plan focal après remplacement d'un module élémentaire conformément au procédé de l'invention.

### MODE DE REALISATION DE L'INVENTION

Les modules élémentaires de détection conformes à l'invention sont réalisés de la manière suivante, étant rappelé que dans l'optique générale de la présente invention, il est possible d'hybrider plusieurs circuits de détections **4, 5** sur un même circuit de lecture **3,** en fonction du nombre de gammes de longueurs d'onde que le détecteur final est destiné à détecter.

Ce circuit de détection **4** est par exemple constitué d'une première couche d'un matériau transparent aux rayonnements infrarouges, d'une épaisseur typique comprise entre 200 à 800 µm, par exemple constitué de CdTe ou de CdZnTe. On dépose sur cette première couche par épitaxie par jet moléculaire par exemple, une seconde couche plus mince en HgCdTe **4',** constituant la couche de détection proprement dite. Celle-ci est donc disposée en face avant du circuit de détection. Il s'agit en l'espèce d'un dispositif avec éclairement face arrière.

Le circuit de lecture **3** est constitué quant à lui d'un empilement de silicium aminci **3'** constituant la face avant du circuit de lecture sur une couche plus épaisse de germanium. La liaison rigide entre ces deux matériaux est assurée soit par de la colle époxy, soit par adhésion moléculaire, et ce de manière connue.

Parallèlement et de manière connue, afin de réaliser l'hybridation du circuit détection sur le circuit de lecture, on implante des surfaces de mouillabilité sur les faces respectivement avant du circuit de détection et avant du circuit de lecture, à l'aplomb les unes des autres pour favoriser l'accroche des microbilles d'indium **8** assurant l'hybridation.

Le substrat ou réseau d'interconnexion **1** sur lequel sont implantés les différents modules ainsi réalisés, présente avantageusement un coefficient de dilatation thermique sur la plage de température de fonctionnement 80K-400/450K très proche de celui du germanium constitutif du substrat de contrainte collé au silicium aminci du circuit de lecture. Ce substrat d'interconnexion est d'ailleurs avantageusement réalisé en germanium. En effet, outre le fait qu'on n'observe pas d'effet bilame entre le circuit de lecture et le substrat d'interconnexion, la mise en oeuvre de germanium est compatible avec le traitement sur les chaînes de fonderie silicium, en particulier pour les dépôts métalliques et les opérations de photolithographie nécessaires à l'obtention des motifs d'indexation permettant d'assurer le positionnement précis des différents modules élémentaires sur ledit substrat d'interconnexion. Il est rappelé que 80K est la température de fonctionnement du détecteur, et 400K la température utilisable pour le collage.

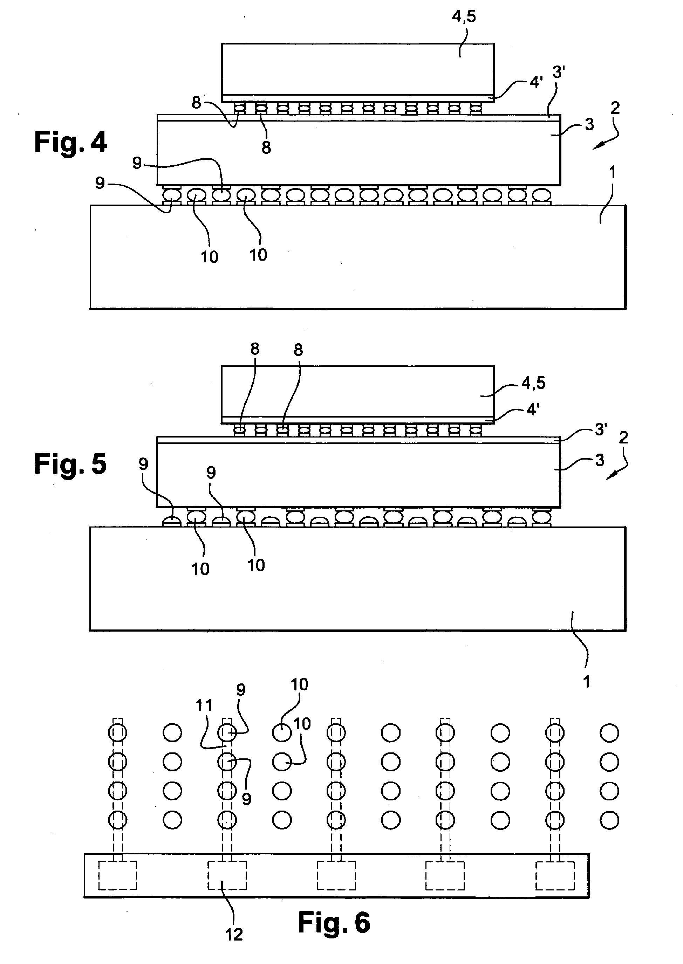

Selon une caractéristique de l'invention, et ainsi qu'on peut bien l'observer sur la figure 6, on implante sur le substrat d'interconnexion **1** non pas un, mais deux réseaux (voire trois) de quantités de matériau destinées à faire fonction de billes d'hybridation.

Le premier réseau **9,** réalisé en indium, est relié par le biais de pistes métalliques conductrices **11** à l'extérieur de la zone d'implantation des modules au niveau de plots d'interconnexion externes **12.** Ces plots sont typiquement réalisés en or, et sont isolés par masquage notamment au moyen d'une résine photosensible ou d'une couche isolante, par exemple réalisée en ZnS lors de l'opération d'hybridation des modules élémentaires.

Corollairement, un second réseau **10** de quantités de matériau d'hybridation de même nature que le réseau **9** est déposé, par exemple en alternance avec ledit premier réseau. Ce second réseau est également réalisé en indium, mais en revanche,, il n'est pas relié à des plots de connexion externes car ce second réseau constitue le dernier réseau utilisable pour l'hybridation.

Dans le cas particulier de l'implantation de trois réseaux (non représentés), cas offrant deux possibilités de réparation, seuls les deux premiers réseaux sont reliés à des plots externes par des pistes métalliques conductrices distinctes des pistes conductrices **11.**

Selon une autre caractéristique de l'invention, le volume de matériau d'hybridation déposé pour ledit second réseau **10** est inférieur à celui dudit premier réseau **9,** l'objectif recherché, lors de l'hybridation du module élémentaire **2** sur le substrat d'interconnexion **1** étant que ledit second réseau ne vienne pas en contact avec ledit module et ne soit pas affecté par cette hybridation dite « nominale ».

L'hybridation nominale du ou des modules élémentaires sur le substrat d'interconnexion intervient de manière traditionnelle par élévation de la température de l'enceinte dans laquelle est positionné l'ensemble des ces différents éléments à une température au moins égale à la température de fusion du matériau d'hybridation, pour assurer l'hybridation effective par effet de refusion.

Préalablement à ces opérations, un flux de matériau sous forme liquide appelé flux de soudure, est déposé sur le substrat d'interconnexion. De manière classique, ce flux de soudure est tout d'abord destiné à assurer la désoxydation du matériau d'hybridation et de limiter sa ré-oxydation lors de l'opération effective de brasure, c'est-à-dire lors de l'opération de refusion.

Ce flux assure également la fonction de transfert de chaleur, mais également de diminution des phénomènes de tension de surface, permettant ainsi audit matériau d'adopter sensiblement la forme d'une bille globalement circulaire, d'où le terme de billes d'hybridation.

En fonctionnement normal, c'est à dire dans le cas où aucun des modules élémentaires ne s'avère défaillant, soit en raison d'une dégradation d'origine mécanique ou autre, soit en raison de son procédé de fabrication, le second réseau **10** ne remplit aucune fonction.

En revanche, en cas de dégradation de l'un de ces modules élémentaires en cours d'opération, voire en cours d'hybridation, il s'est avéré souhaitable de pouvoir remplacer le module en question, et c'est dans cette hypothèse que le second réseau **10** va devenir opérationnel.

A cet effet, on retire tout d'abord la couche de protection des plots de connexion externes **12** reliés au premier réseau **9** de billes d'hybridation nominale au niveau du module défectueux.

Puis, on fait migrer par capillarité dans la zone de connectique correspondante, c'est-à-dire entre ledit module défectueux et le substrat d'interconnexion, une solution conductrice de l'électricité, et par exemple un flux d'hybridation, cette migration étant localisée au niveau du seul module défectueux. La migration dudit flux peut être aisément réduite au seul module défectueux en choisissant un apport réduit (micro dépôt par seringue) couplé à une migration par capillarité. En tout état de cause, tout dépôt excédentaire serait sans influence sur les autres billes car le transfert de matière (consommation de l'indium) ne concerne que les billes couplées électriquement au plot de connexion externe.

En raison de la nature conductrice de ce flux d'une part, et de la différence des potentiels normaux d'oxydoréduction respectivement de l'indium (-0,33 volts) constitutif du matériau d'hybridation, et de l'or (+0,99 volts) constitutif des plots de connexion externes d'autre part, il se produit une réaction électrochimique ou effet pile, dont la conséquence est la consommation des billes d'hybridation dudit premier réseau **9** soumises à cette différence de potentiels redox. Au surplus, on sélectionne les billes à supprimer, et à tout le moins fortement réduire par le biais des plots de connexion externes **12.** Le bouclage électrique apporté par la solution conductrice conduit à un transfert immédiat de matériau. En présence d'or et d'indium, le déplacement de l'indium vers l'or conduit à la complète disparition de la bille d'indium (hors composé intermétallique Or-In.

Ainsi, en raison du fait que le second réseau **10** de billes d'hybridation n'est pas relié aux plots de connexion externes **12,** celui-ci n'est pas affecté par les réactions corrosives résultant de cette réaction électrochimique. Seul le premier réseau **9** est ainsi consommé, totalement ou partiellement, en fonction de la durée de soumission de cette zone d'interconnexion au flux ainsi introduit.

Ce faisant, il devient possible après un certain temps de réaction, typiquement quelques secondes, de retirer le module élémentaire défectueux, qui n'est plus alors relié mécaniquement-audit substrat d'interconnexion **1.**

Avantageusement, on procède alors à une phase de nettoyage de la zone ainsi découverte du substrat d'interconnexion. Dans le cas particulier de l'utilisation d'un flux d'hybridation, la complète élimination passe généralement par un rinçage au flux pur suivi d'une aspersion d'eau désionisée (par exemple au moyen d'un jet haute pression) puis d'un séchage sous azote gazeux

La mise en place du module élémentaire de remplacement **2'** s'effectue alors de la manière suivante. On redépose une nouvelle couche de flux d'hybridation sur la zone concernée du substrat d'interconnexion et notamment sur les billes constitutives du second réseau **10.** On procède à un soufflage pour limiter la quantité de flux. Ce soufflage peut être orienté vers l'extérieur du réseau d'interconnexion afin de canaliser l'élimination des surplus. La présence d'éventuelles traces de flux à l'aplomb des autres modules serait sans impact sur la tenue de ces modules. L'ensemble du plan focal est à nouveau nettoyé après réparation pour élimination des résidus de flux.

Puis, on positionne le module élémentaire de remplacement **2'** en lieu et place du module remplacé, et on procède à une phase d'hybridation à l'instar de ce qui a été précédemment décrit.

Selon une variante de l'invention, au lieu de déposer le flux d'hybridation sur le substrat d'interconnexion, il est possible de déposer ledit flux sur la face arrière du module élémentaire de remplacement.

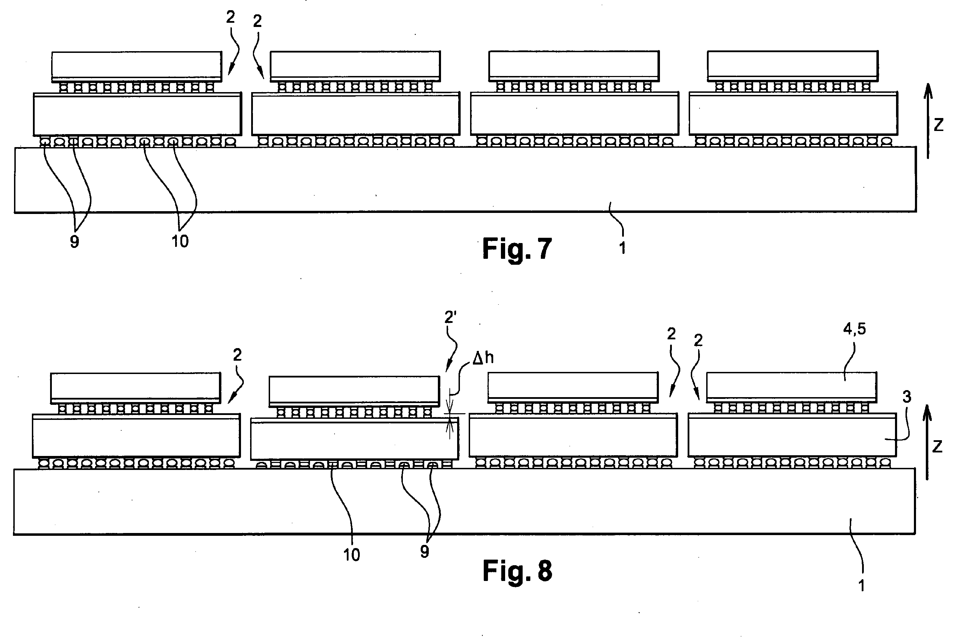

On conçoit qu'en raison de la plus faible quantité de matériau d'hybridation constitutif du second réseau **9,** la cote selon l'axe Z des photosites dudit module de remplacement **2'** ne correspond pas à la cote originale du module remplacé 2, la différence de volume des billes dudit réseau **10** se traduisant par une plus faible hauteur h des billes correspondantes. On a matérialisé par Δh cette variation de hauteur au sein de la figure 8, cette variation étant susceptible d'atteindre quelques micromètres. Cette défocalisation des photosites concernés est préjudiciable à la qualité de la matrice de détecteurs correspondante.

Afin de palier cette variation de cote, on sélectionne alors un module élémentaire dont le circuit de détection **4** (ou dont le circuit de lecture) présente une épaisseur supérieure, pour ainsi rattraper la cote originale selon l'axe Z.

On conçoit dès lors le remplacement aisé d'un module élémentaire défectueux au sein d'un plan focal comportant une pluralité de tels modules juxtaposés ou aboutés les uns avec les autres au moyen du procédé de l'invention.

La présente invention a été décrite en mettant en oeuvre la combinaison HgCdTe/CdTe/Ge, dans laquelle la couche active a été déposée par épitaxie par jets moléculaires sur un substrat en Germanium.

Cependant, elle peut également être mise en oeuvre avec une fonction de détection réalisée par des puits quantiques élaborés par épitaxie sur substrats AsGa, ou encore avec un circuit de détection constitué d'un substrat InSb monolithique, voire avec comme matériau de détection du silicium, pour le domaine spectral visible.

## Revendications

1. Procédé pour la réalisation d'une matrice de détecteurs de rayonnements électromagnétiques, constituée d'une pluralité de modules de détection élémentaires (2) rapportés sur un substrat d'interconnexion (1), lesdits modules élémentaires (2) étant eux-mêmes composés d'au moins un circuit de détection (4, 5) dudit rayonnement associé à un circuit de lecture (3) par hybridation, ledit circuit de lecture (3) étant lui-même solidarisé au substrat d'interconnexion (1) par hybridation, le procédé consistant :
- à déposer sur le substrat d'interconnexion (1) un nombre déterminé de quantités de matériau de brasure ou d'hybridation, destinées à constituer les billes d'hybridation avec les modules élémentaires (2), et ce selon au moins deux réseaux, respectivement un premier réseau (9) pour l'hybridation nominale, et au moins un second réseau (10), au moins ledit réseau pour l'hybridation nominale étant relié à des plots d'interconnexion par le biais de pistes métalliques conductrices, les dépôts de matériau de brasure ou d'hybridation du ou desdits second réseau(x) (10) étant inférieurs en volume à ceux dudit premier réseau (9) ;
- à déposer sur le substrat d'interconnexion muni de ces au moins deux réseaux de matériau de brasure, un flux de matériau sous forme liquide remplissant les fonctions de désoxydation dudit matériau de brasure ou d'hybridation, de limitation de ré-oxydation dudit matériau après réalisation effective de ladite brasure, de transfert de chaleur, outre de diminution des tensions de surface ;
- à rapporter les modules élémentaires à hybrider sur le substrat d'interconnexion ;
- puis à élever la température de l'enceinte au sein de laquelle sont positionnés les différents éléments à hybrider jusqu'à atteindre au moins la température de fusion du matériau de brasure ou d'hybridation afin d'assurer la brasure ou l'hybridation effective des modules sur le substrat d'interconnexion entre eux par effet de refusion.

2. Procédé pour la réalisation d'une matrice de détecteurs de rayonnements électromagnétiques selon la revendication 1, le procédé où le matériau de brasure desdits premier (9) et second (10) réseaux sont de même nature.

3. Procédé pour pourvoir au remplacement d'un module de détection élémentaire (2) rapporté par hybridation sur un substrat d'interconnexion (1) comportant une pluralité de tels modules élémentaires juxtaposés ou aboutés les uns à coté des autres afin de définir un plan focal de grandes dimensions, lesdits modules élémentaires (2) étant rapportés sur le substrat d'interconnexion par un premier réseau (9) de billes d'hybridation, lesdites billes étant connectées à un ou plusieurs plots de connexion externes (12) par une ou plusieurs pistes conductrices (11), le substrat d'interconnexion comportant également au moins un second réseau (10) de billes d'hybridation, les dimensions des billes dudit au moins second réseau étant inférieures à celles constitutives dudit premier réseau d'hybridation (9), le procédé consistant :
- tout d'abord, à retirer la couche de protection dont sont revêtus le ou les plots de connexion externes (12) reliés électriquement audit premier réseau (9) de billes d'hybridation ;
- puis à faire migrer, notamment par capillarité, une solution électriquement conductrice entre ledit module élémentaire à remplacer (2) et le substrat d'interconnexion, afin d'induire par réaction électrochimique, la dissolution à tout le moins partielle dudit premier réseau (9) de billes d'hybridation ;
- à retirer le module à remplacer ;
- puis à hybrider le module de remplacement (2') par une nouvelle élévation de température de l'enceinte dans laquelle est située l'ensemble à une température au moins égale à la température de fusion du matériau constitutif desdites billes d'hybridation du second réseau (10) pour assurer la solidarisation par refusion.

4. Procédé selon la revendication 3, où le matériau de brasure desdits premier (9) et second (10) réseaux sont de même nature.

5. Procédé selon l'une des revendications 3 et 4, où le module de remplacement (2') comporte un circuit de détection ou un circuit de lecture plus épais que le circuit de détection ou le circuit de lecture du module remplacé, afin de compenser la variation de hauteur des billes d'hybridation entre les deux réseaux.

6. Procédé selon l'une des revendications 3 à 5, où le dépôt de la solution électriquement conductrice est réalisé sur la face arrière du module élémentaire à remplacer (2).

## Claims

1. A method for producing a matrix of electromagnetic radiation detectors, consisting of a plurality of elementary detection modules (2) mounted on an interconnection substrate (1), said elementary modules (2) themselves comprising at least one circuit (4, 5) for detecting said radiation associated with a hybridization read circuit (3), said read circuit (3) being itself joined to the interconnection substrate (1) by hybridization, the method consisting:
- in depositing on the interconnection substrate (1) a predefined number of quantities of solder or hybridization material, intended to constitute the hybridization bumps with the elementary modules (2), and in at least two arrays, respectively a first array (9) for the nominal hybridization, and at least one second array (10), at least said array for nominal hybridization being connected to interconnection pins via conducting metal tracks, the deposits of solder or hybridization material of said second array or arrays (10) being lower in volume than those of said first array (9);
- in depositing a soldering material on the interconnection substrate provided with these at least two arrays, a flux of material in liquid form performing the functions of deoxidation of said solder or hybridization material, of limiting the reoxidation of said material after effective completion of said soldering, of heat transfer, in addition to decreasing the surface tension;
- in mounting the elementary modules to be hybridized on the interconnection substrate;
- then in raising the temperature of the chamber in which the various elements to be hybridized are positioned until reaching at least the melting point of the solder or hybridization material in order to complete the effective soldering or hybridization of the modules to the interconnection substrate together by reflow effect.

2. The method for producing a matrix of electromagnetic radiation detectors as claimed in claim 1, wherein the soldering material of said first (9) and second (10) arrays are of the same type.

3. A method to provide for replacing an elementary detection module (2) mounted by hybridization on an interconnection substrate (1) comprising a plurality of such elementary modules juxtaposed or joined together side by side in order to define a large focal plane, said elementary modules (2) being mounted on the interconnection substrate by a first array (9) of hybridization bumps, said bumps being connected to one or more external connection pins (12) by one or more conducting tracks (11), the interconnection substrate also comprising at least one second array (10) of hybridization bumps, the dimensions of the bumps of said at least second array being lower than those constituting said first hybridization array (9), the method consisting:
- first, in removing the protective layer applied to the external connection pin or pins (12) electrically connected to said first array (9) of hybridization bumps;
- then in causing to migrate, in particular by capillarity, an electrically conducting solution between said elementary module to be replaced (2) and the interconnection substrate, in order to cause, by electrochemical reaction, the at least partial dissolution of said first array (9) of hybridization bumps;
- in removing the module to be replaced;
- then in hybridizing the replacement module (2') by a new temperature rise of the chamber in which the assembly is located to a temperature at least equal to the melting point of the material constituting said hybridization bumps of the second array (10), to join them by reflow.

4. The method as claimed in claim 3, wherein the materials for soldering said first (9) and second (10) arrays are of the same type.

5. The method as claimed in either of claims 3 and 4, wherein the replacement module (2') comprises a detection circuit or a read circuit that is thicker than the detection circuit or the read circuit of the replaced module, in order to compensate for the variation in height of the hybridization bumps between the two arrays.

6. The method as claimed in one of claims 3 to 5, wherein the electrically conducting solution is deposited on the back of the elementary module to be replaced (2).

## Patentansprüche

1. Verfahren zur Herstellung einer Matrix von Detektoren für elektromagnetische Strahlungen, die aus einer Mehrzahl von Einzelerfassungsmodulen (2) besteht, die auf einem Verbindungssubstrat (1) angebracht sind, wobei die Einzelmodule (2) ihrerseits aus mindestens einer Schaltung (4, 5) zur Erfassung der Strahlung zusammengesetzt sind, der eine Leseschaltung (3) durch Hybridisierung zugeordnet ist, wobei die Leseschaltung (3) ihrerseits mit dem Verbindungssubstrat (1) durch Hybridisierung fest verbunden ist, wobei das Verfahren darin besteht, dass
- auf dem Verbindungssubstrat (1) eine bestimmte Anzahl von Löt- oder Hybridisierungswerkstoffmengen aufgebracht werden, die dazu bestimmt sind, die Kugeln zur Hybridisierung mit den Einzelmodulen (2) zu bilden, und zwar gemäß mindestens zwei Netzen, und zwar einem ersten Netz (9) für die Nennhybridisierung und mindestens einem zweiten Netz (10), wobei mindestens das Netz für die Nennhybridisierung mit Verbindungsstellen über leitende Metallbahnen verbunden ist, wobei die Löt- oder Hybridisierungswerkstoffaufträge des oder der zweiten Netze (10) ein kleineres Volumen als diejenigen des ersten Netzes (9) haben;
- auf dem Verbindungssubstrat, das mit diesen mindestens zwei Lötwerkstoffnetzen versehen ist, ein Materialfluss in flüssiger Form aufgebracht wird, der die Funktionen der Entoxidierung des Löt- oder Hybridisierungswerkstoffs, der Begrenzung der Rückoxidierung dieses Werkstoffs nach tatsächlicher Durchführung der Verlötung, der Wärmeübertragung außer der Verringerung der Oberflächenspannungen erfüllt;
- die zu hybridisierenden Einzelmodule auf dem Verbindungssubstrat angebracht werden;
- dann die Temperatur der Kammer, in der die verschiedenen zu hybridisierenden Elemente angeordnet sind, erhöht wird, bis mindestens die Schmelztemperatur des Löt- oder Hybridisierungswerkstoffs erreicht ist, um die tatsächliche Verlötung oder Hybridisierung der Module auf dem Verbindungssubstrat miteinander durch Rückschmelzwirkung zu gewährleisten.

2. Verfahren zur Herstellung einer Matrix von Detektoren für elektromagnetische Strahlungen nach Anspruch 1, bei dem der Lötwerkstoff des ersten (9) und des zweiten (10) Netzes von derselben Art ist.

3. Verfahren zur Durchführung des Austausches eines Einzelerfassungsmoduls (2), das durch Hybridisierung auf einem Verbindungssubstrat (1) angebracht ist, das eine Mehrzahl von solchen Einzelmodulen umfasst, die nebeneinandergesetzt oder aneinandergefügt sind, um eine Brennebene mit großen Abmessungen zu bilden, wobei die Einzelmodule (2) auf dem Verbindungssubstrat durch ein erstes Netz (9) von Hybridisierungskugeln angebracht sind, wobei die Kugeln mit einer oder mehreren äußeren Verbindungsstellen (12) durch eine oder mehrere leitende Bahnen (11) verbunden sind, wobei das Verbindungssubstrat ferner mindestens ein zweites Netz (10) von Hybridisierungskugeln umfasst, wobei die Abmessungen der Kugeln dieses mindestens zweiten Netzes kleiner als diejenige sind, die das erste Hybridisierungsnetz (9) bilden, wobei das Verfahren darin besteht, dass
- zunächst die Schutzschicht abgezogen wird, mit der die mit dem ersten Netz (9) von Hybridisierungskugeln elektrisch verbundenen äußeren Verbindungsstellen (12) bedeckt sind;
- man dann eine elektrisch leitende Lösung zwischen dem auszutauschenden Einzelmodul (2) und dem Verbindungssubstrat insbesondere durch Kapillarität wandern lässt, um die allermindestens teilweise Auflösung des ersten Netzes (9) von Hybridisierungskugeln durch elektrochemische Reaktion zu bewirken;
- das auszutauschende Modul entfernt wird;
- dann das Austauschmodul (2') durch eine neuerliche Temperaturerhöhung der Kammer, in der die Einheit angeordnet ist, auf eine Temperatur mindestens gleich der Schmelztemperatur des die Hybridisierungskugeln des zweiten Netzes (10) bildenden Werkstoffs hybridisiert wird, um die feste Verbindung durch Rückschmelzung zu gewährleisten.

4. Verfahren nach Anspruch 3, bei dem der Lötwerkstoff des ersten (9) und des zweiten (10) Netzes von derselben Art sind.

5. Verfahren nach einem der Ansprüche 3 und 4, bei dem das Austauschmodul (2') eine Erfassungsschaltung oder Leseschaltung umfasst, die dicker als die Erfassungsschaltung oder die Leseschaltung des ersetzten Moduls ist, um die Höhenänderung der Hybridisierungskugeln zwischen den Netzen auszugleichen.

6. Verfahren nach einem der Ansprüche 3 bis 5, bei dem der Auftrag der elektrisch leitenden Lösung auf der Rückseite des auszutauschenden Einzelmoduls (2) vorgenommen wird.
